# FASCICULE DE BREVET EUROPEEN

(11) **EP 2 168 082 B1**
(45) Date de publication et mention de la délivrance du brevet: **27.02.2013**
(21) Numéro de dépôt: 08760869.1
(22) Date de dépôt: 11.06.2008
(51) Int. Cl.: G06K 19/077

(54) **PROCEDE DE FABRICATION DE CARTES COMPRENANT AU MOINS UNE UNITE ELECTRONIQUE**
VERFAHREN ZUR HERSTELLUNG VON MINDESTENS EINE ELEKTRONISCHE EINHEIT ENTHALTENDEN LEITERPLATTEN
METHOD FOR MANUFACTURING BOARDS INCLUDING AT LEAST ONE ELECTRONIC UNIT

(30) Priorité: 26.06.2007 EP 07111079
(43) Date de publication de la demande: 31.03.2010
(73) Titulaire: NagraID SA, 2301 La Chaux-de-Fonds (CH)
(72) Inventeur: DROZ, François, CH-2035 Corcelles (CH)
(74) Mandataire: Surmely, Gérard
(86) Numéro de dépôt international: PCT/EP2008/057320
(87) Numéro de publication internationale: WO 2009/000653

(56) Documents cités:
- EP-A- 0 570 784
- EP-A- 0 720 123
- EP-A- 1 244 055
- US-A1- 2005 179 122

## Description

La présente invention concerne un procédé de fabrication de cartes comprenant chacune au moins une unité électronique, en particulier un module électronique comprenant un affichage électronique. La carte obtenue par le procédé selon l'invention est par exemple une carte du type bancaire, en particulier selon la norme ISO correspondante. Cependant, la présente invention peut s'appliquer également à d'autres types de cartes électroniques ayant divers profils, notamment circulaire.

En particulier, le procédé de fabrication de cartes selon l'invention prévoit de réaliser une pluralité de cartes ou de corps de carte sous forme d'une plaque dans laquelle chaque carte ou corps de carte est ensuite découpé. Cette plaque est formée par une pluralité d'unités électroniques et une résine enrobant au moins partiellement ces unités électroniques. Pour ce faire, le procédé comprend une étape d'apport d'une résine sous forme liquide sur et/ou sous la pluralité d'unités électroniques.

Le brevet EP 0 570 784 décrit dans un mode de mise en oeuvre particulier un procédé de fabrication de cartes comprenant un ensemble électronique, en particulier un transpondeur, qui est placé dans une ouverture principale d'un cadre de positionnement. Le transpondeur et le cadre de positionnement sont noyés dans un liant pouvant être apporté sous forme de liquide visqueux, notamment dans une résine. Le cadre de positionnement dans le document EP 0 570 784 sert uniquement à délimiter une zone interne pour le transpondeur, formé d'un circuit intégré et d'une bobine, à l'intérieur de la carte. Ainsi, lors de l'application d'une pression sur les divers éléments et sur le liant pour former une carte, le transpondeur est maintenu dans une zone interne de chaque carte prévue alors que le liant peut s'étendre pour former une couche traversante des cartes. L'homme du métier trouve ainsi dans ce document de brevet un procédé de fabrication de cartes permettant d'intégrer dans celles-ci des transpondeurs ou d'autres unités électroniques de formes diverses et même complexes. Cependant, l'apport de la résine et son dépôt sur et/ou sous les unités électroniques et le cadre de positionnement est une étape délicate; et ceci d'autant plus que l'unité électronique présente une forme complexe avec des épaisseurs variables.

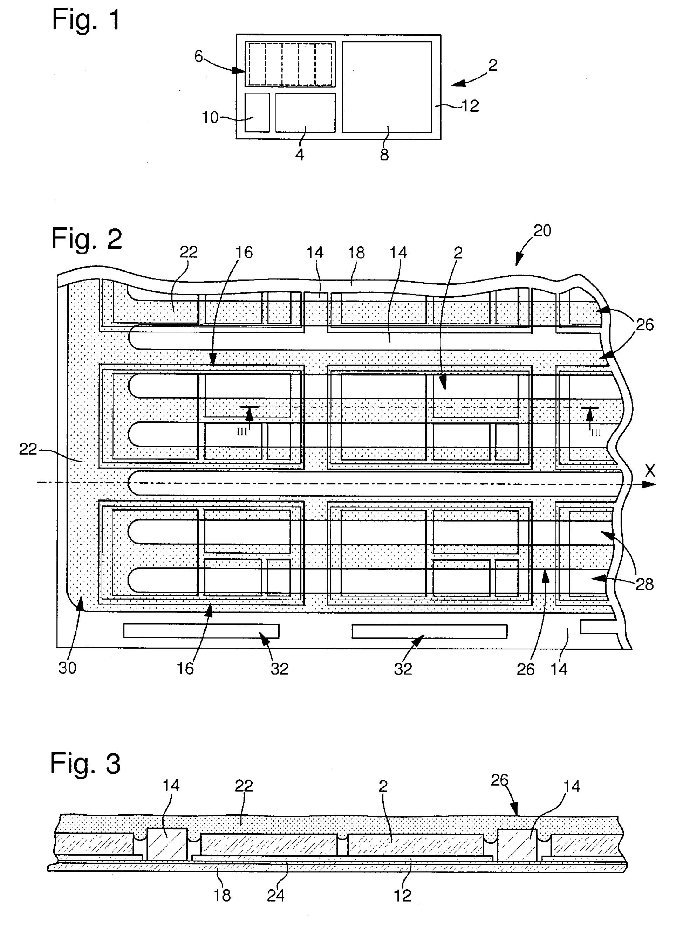

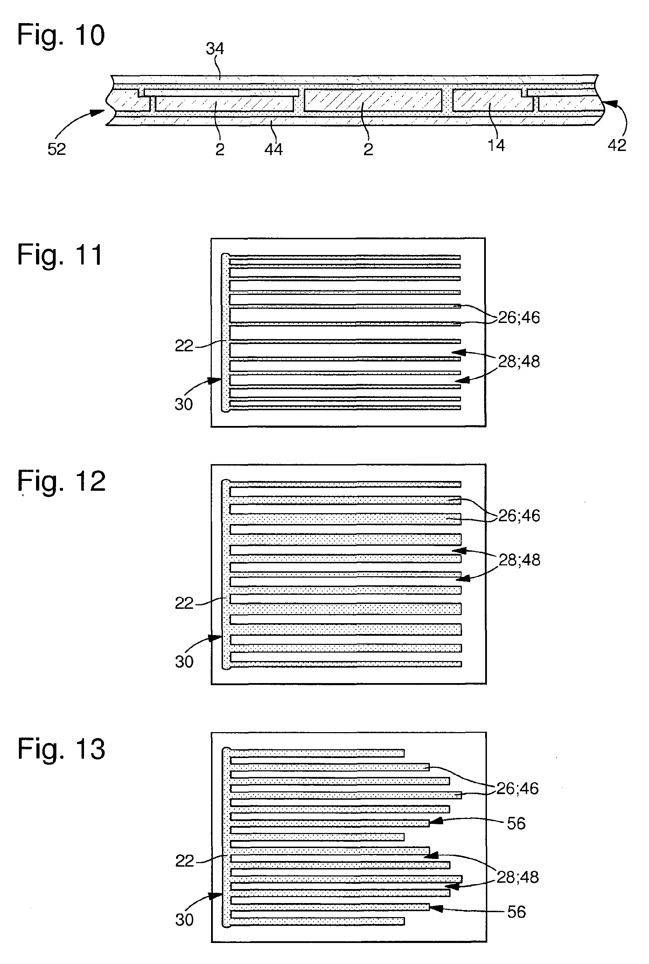

Le document EP 1244055 concerne un procédé de fabrication de cartes électroniques dans lequel il est prévu d'apporter sur les éléments électroniques au moins un tas de résine qui est ensuite étaler par une sorte de lame, avec ou sans interposition d'un film plastique. Le document EP 0720123 enseigne, dans un mode de réalisation (figure 12), d'apporter une résine à l'aide d'un appareil de remplissage des ouvertures d'une feuille intermédiaire dans laquelle sont agencés des circuits électroniques. Le surplus de résine est poussé vers l'avant par un rouleau presseur agissant sur une feuille supérieure déposée progressivement sur les ouvertures remplies de résine. Le document US 2005/0179122 enseigne un enrobage de circuit intégré pour former un module électronique. Pour ce faire, il est prévu un masque avec une ouverture dans laquelle est agencé le circuit électronique (figure 3). Une buse dépose de la résine en tas sur le masque. Ensuite la résine est poussée dans l'ouverture du masque à l'aide d'une sorte de lame dont l'extrémité glisse sur la surface supérieure du masque.

Le but de la présente invention est de proposer un procédé de fabrication perfectionné permettant de réduire la présence de bulles d'air résiduel dans les cartes fabriquées avec un apport de résine sous forme liquide visqueux. Un autre but est d'améliorer la planéité des cartes obtenues.

A cet effet, dans un premier mode de mise en oeuvre, le procédé de fabrication de cartes selon l'invention comprend une étape d'apport d'au moins une partie de ladite résine sous forme liquide sur une pluralité d'unités électroniques et est caractérisé en ce que:
- ladite au moins une partie de la résine est déposée sur la pluralité d'unités électroniques au moyen d'une pluralité de buses dans une installation d'apport de cette résine, cette installation étant agencée de manière que la pluralité de buses et la pluralité d'unités électroniques apportées dans cette installation puissent avoir entre elles un mouvement relatif selon une direction ayant au moins une composante horizontale;
- ladite pluralité de buses subit, lors dudit dépôt de ladite au moins une partie de ladite résine, un déplacement relativement à la pluralité d'unités électroniques selon ladite direction de manière à engendrer sur cette pluralité d'unités électroniques des cordons de résine orientés selon cette direction et présentant initialement entre eux des sillons; et
- la résine déposée est ensuite étendue progressivement selon ladite direction par des moyens d'étalement de cette résine, la pluralité d'unités électroniques et ces moyens d'étalement ayant entre eux un mouvement relatif selon ladite direction.

Selon un deuxième mode de mise en oeuvre du procédé selon l'invention, il est prévu une étape d'apport d'au moins une première partie de la résine sous forme liquide sous la pluralité d'unités électroniques, ce procédé étant caractérisé en ce que :
- ladite au moins une première partie de la résine est déposée sur une feuille ou une couche quelconque, au dessus de laquelle il est ensuite prévu d'agencer la pluralité d'unités électroniques, au moyen d'une pluralité de buses dans une installation d'apport de cette résine, cette installation étant agencée de manière que la pluralité de buses et la feuille ou couche apportée dans cette installation puissent avoir entre elles un mouvement relatif selon une première direction sensiblement parallèle à cette feuille ou couche dans la zone de dépôt de la résine;
- ladite pluralité de buses subit, lors dudit dépôt de ladite au moins une partie de ladite résine sur la feuille ou couche, un déplacement relativement à cette feuille ou couche selon ladite première direction de manière à engendrer des cordons de résine (46) orientés selon cette première direction et présentant initialement entre eux des sillons (48); et
- ladite pluralité d'unités électroniques est apportée sur les cordons de résine.

On remarquera que la feuille ou couche peut être une couche des cartes fabriquées ou une feuille de travail destinée à être enlevée en cours de fabrication des cartes ou avant utilisation de ces cartes.

Selon une variante préférée de ce deuxième mode de mise en oeuvre du procédé de l'invention, il est également prévu d'apporter une deuxième partie de la résine sous forme liquide sur la pluralité d'unités électroniques de manière similaire au premier mode de mise en oeuvre mentionné précédemment. En particulier, la viscosité de la partie de résine apportée initialement sur ladite feuille ou couche et l'apport de la pluralité d'unités électroniques peuvent être prévus pour que lesdits moyens d'étalement de la deuxième partie de la résine déposée sur la pluralité d'unités électroniques servent également à étaler, au moins dans une phase terminale de l'étalement de la première partie de la résine déposée directement sur la feuille ou couche, cette première partie de résine. Dans ce cas-ci, on prévoit de préférence que l'orientation des premiers cordons de résine déposés initialement sur la feuille ou couche soit sensiblement la même que l'orientation des deuxièmes cordons de résine déposés ensuite sur la pluralité d'unités électroniques.

Grâce aux caractéristiques du procédé de fabrication de cartes selon l'invention, les sillons initialement présents entre les cordons de résine déposés permet à l'air de s'échapper aisément lorsqu'un dispositif presseur des moyens d'étalement est actionné pour presser progressivement sur la résine selon la direction définie par les cordons de résine déposés. L'étalement de la résine est donc opéré progressivement le long de la direction d'orientation des cordons de résine. Ainsi, l'air momentanément enfermé par la résine est poussé en avant par les moyens d'étalement, cet air se frayant aisément un chemin jusqu'aux sillons encore présent en amont de ces moyens d'étalement. Ces sillons agencés entre les cordons de résine définissent des tranchées d'évacuation de l'air résiduel et empêchent que des bulles d'air résiduel restent enfermées dans la résine et finalement dans le corps de carte formé par cette résine.

La présente invention sera exposée ci-après de manière plus détaillée à l'aide de la description suivante, faite en référence aux dessins annexés donnés à titre d'exemples nullement limitatifs, dans lesquels :
- la figure 1 représente schématiquement une unité électronique susceptible d'être incorporée dans une carte électronique selon l'invention;
- la figure 2 est une vue partielle de dessus montrant la résine déposée sur une pluralité d'unités électroniques selon un premier mode de mise en oeuvre du procédé de l'invention;
- la figure 3 est une vue schématique en coupe selon la ligne II I-III de la figure 2;
- la figure 4 est une vue schématique de dessus montrant un rouleau presseur qui étale les cordons de résine déposés selon une caractéristique du procédé de l'invention;
- la figure 5 est une vue schématique en coupe selon la ligne V-V de la figure 4;
- la figure 6 est une vue partielle en coupe d'une plaque formant une pluralité de cartes obtenue selon le procédé décrit à l'aide des figures précédentes;
- la figure 7 est une vue partielle de dessus représentant schématiquement un deuxième mode de mise en oeuvre du procédé selon l'invention;
- la figure 8 est une vue partielle en coupe selon la ligne VIII-VIII de la figure 7 mais suite à des étapes supplémentaires relativement à cette figure 7; ce qui correspond à une variante préférée du deuxième mode de mise en oeuvre du procédé selon l'invention;
- la figure 9 montre schématiquement en coupe l'étape d'étalement des cordons de résine à l'aide de rouleaux presseurs sur l'ensemble des éléments représentés à la figure 8;
- la figure 10 est une vue en coupe de la plaque obtenue selon le procédé décrit à l'aide des figures 8 et 9; et
- les figures 11 à 13 représentent schématiquement trois variantes de dépôt des cordons de résine selon l'invention.

A la figure 1 est représentée schématiquement, à titre d'exemple nullement limitatif, une unité électronique 2 comprenant un circuit intégré 4, un affichage électronique 6, une batterie 8 et un interrupteur 10 qui sont agencés sur un support 12. Une telle unité électronique présente une forme complexe avec diverses épaisseurs et des fentes ou espaces libres entre les divers éléments.

A l'aide des figures 2 à 6, on décrira ci-après un premier mode de mise en oeuvre du procédé de fabrication de cartes selon l'invention. Plusieurs unités électroniques 2 sont agencées respectivement dans plusieurs ouvertures 16 d'une structure ajourée 14. La structure 14 et les unités 2 sont collées sur une feuille 18 qui présente à sa surface un film de colle 24. Ces divers éléments forment un ensemble préfabriqué 20, lequel est apporté dans une installation de dépôt d'une résine liquide 22. Cette résine 22 est apportée pour remplir les espaces restant dans les ouvertures 16 et recouvrir la structure ajourée 14 et la pluralité d'unités électroniques 2. Par la suite, cette structure ajourée est aussi nommée plaque ou plaque ajourée.

Selon l'invention, la résine 22 est déposée sur l'ensemble 20 au moyen d'une pluralité de buses (non représentée). Ces buses sont agencées par exemple en ligne sur un support approprié. L'apport de la résine à chaque buse peut être effectué individuellement ou l'apport peut être commun à la pluralité de buses, notamment à l'aide d'un tuyau sur lequel les buses sont montées. L'homme du métier a plusieurs possibilités pour réaliser une telle installation de dépôt de résine. L'installation de dépôt de résine est agencée de manière que la pluralité de buses et la pluralité d'unités électroniques apportées dans cette installation puissent avoir entre elles un mouvement relatif selon une direction X dans le plan général de l'ensemble 20 correspondant au plan général de la figure 2. Ainsi, il est prévu lors du dépôt de la résine 22 sur l'ensemble 20 que la pluralité de buses subit un déplacement relativement à l'ensemble 20 de manière à déposer la résine sous forme de cordon de résine 26 présentant initialement entre eux des sillons 28. Ces sillons 28 définissent des canaux d'évacuation de l'air situés dans les espaces restant des ouvertures 16 de la plaque 14.

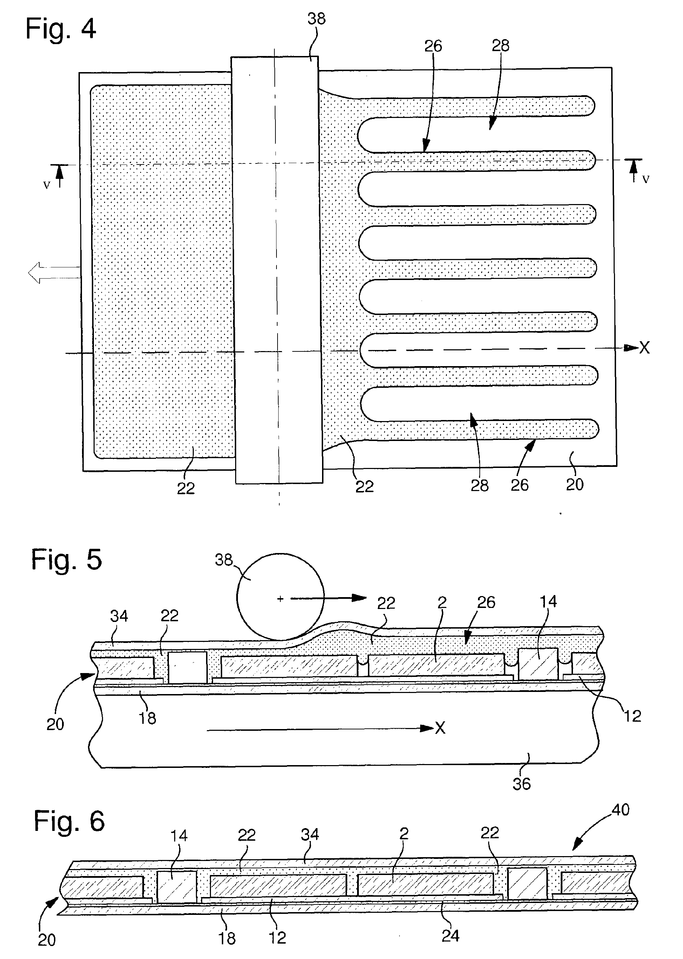

A l'extrémité de la plaque où le dépôt de la résine commence, il est possible de rester dans une position stationnaire pendant une courte période ou de déplacer initialement les buses transversalement à la direction du mouvement relatif servant à former les cordons 26. On obtient ainsi une zone continue de résine 30 à cette extrémité de l'ensemble 20. Ceci permet d'avoir une petite réserve de résine pour assurer un remplissage correct dès la première rangée d'ouvertures 16. Sur les bords de la plaque 14, on a prévu des ouvertures 32 formant des petits réservoirs de récupération de la résine lors de l'étape au cours de laquelle cette résine est étendue par des moyens d'étalement prévus à cet effet. Cette dernière étape sera décrite ci-après à l'aide des figures 4 et 5.

Sur l'ensemble 20 et la résine 22 est apportée une feuille supérieure 34 (cette feuille est en transparence à la figure 4 pour laisser apparaître la résine 22). Pour simplifier le dessin de la figure 4, seul le pourtour extérieur de l'ensemble 20 a été représenté. Cet ensemble 20, la résine 22 et la feuille supérieure 34 sont placés sur un support plan 36, en particulier sur une table de travail ou un plan quelconque agencé dans l'installation servant à étendre la résine de manière à former une plaque pleine et sensiblement plane. Un rouleau presseur 38 forme avec le support 36 des moyens d'étalement de la résine. L'installation est prévue de manière que l'ensemble 20 comprenant la pluralité d'unités électroniques et le dispositif presseur 38 présentent entre eux un mouvement relatif selon la direction X définie par les cordons de résine 26. De préférence, le rouleau presseur 38 est positionné à une extrémité de l'ensemble 20, en particulier derrière la zone continue de résine 30. Ensuite, le rouleau avance progressivement en pressant sur la résine par l'intermédiaire de la feuille supérieure 34 de manière à remplir les espaces restant des ouvertures 16 et à recouvrir les unités 2. A la figure 4, on a représenté le rouleau presseur fixe avec l'ensemble 20 et la résine 22 subissant un déplacement selon la direction X, dans le sens arrière, de sorte que le rouleau presseur 38 présente un mouvement relativement à l'ensemble 20, dans le sens avant. Ceci est donc équivalent à la représentation faite à la figure 5 où l'ensemble 20 reste stationnaire alors que le rouleau presseur 38 est déplacé selon la direction X en maintenant un écartement constant avec le support 36.

On notera ici que d'autres dispositifs presseurs peuvent être prévus. En particulier, une installation performante est équipée de paires de rouleaux presseurs entre lesquels les éléments et la résine formant les cartes ou corps de carte sont introduits. De préférence, ces éléments et la résine sont tirés entre les rouleaux qui sont montés libres sur leurs axes de rotation respectifs. Pour ce faire, on saisit l'ensemble 20 et/ou les feuilles 18 et 34 à l'aide de moyens de préhension. Chaque rouleau inférieur est de préférence agencé dans un plan de travail dont la surface, au moins au voisinage de ce rouleau, est située sensiblement au niveau de la ligne supérieure de la surface cylindrique du rouleau.

Avantageusement, la pression est effectuée d'une extrémité de l'ensemble 20 à une seconde extrémité opposée de cet ensemble selon la direction X définie par les cordons de résine 26. Le remplissage des ouvertures 16 est ainsi effectué progressivement et l'air résiduel peut s'échapper aisément par les sillons 28 restant au moins partiellement devant le rouleau presseur 38. En effet, même si ces sillons sont déjà partiellement refermés dû à un étalement transversal des cordons de résine 26, notamment sous le poids de la feuille 34 apportée sur ces cordons, une certaine efficacité d'évacuation des bulles d'air résiduel demeure.

On remarquera que la présente invention s'applique de manière similaire aussi dans le cas où il n'est pas prévu d'apporter une plaque ajourée 14, mais seulement une pluralité d'unités électroniques 2. Le procédé selon l'invention s'applique également sans la présence de feuilles ou couches externes 18 et 34. Dans une variante simple, on peut donc avoir seulement une pluralité d'unités électroniques posée sur un plan de travail et la résine déposée selon le procédé de l'invention, c'est-à-dire en déposant la résine sous forme de cordons présentant au moins initialement entre eux des sillons. Les unités électroniques peuvent être apportées préalablement au dépôt de résine ou simultanément à celui-ci dans un procédé de fabrication en continu de cartes ou corps de carte, les unités électroniques étant posées en amont de la zone de dépôt de résine relativement au sens de défilement du procédé en continu. On notera encore que la plaque ajourée peut être une bande ajourée qui est déroulée en continu et apportée avec les unités électroniques ou de manière individuelle.

Dans le premier mode de mise en oeuvre décrit ici, les divers éléments sont placés sur un support ou un plan de travail 36. Ce support peut être prévu mobile ou stationnaire. Il peut présenter notamment un tapis supérieur susceptible de subir un déplacement selon l'axe X. Dans une autre variante, l'ensemble des éléments peut être tiré par des moyens de préhension de cet ensemble, lequel passe entre deux rouleaux presseurs qui peuvent être montés librement sur leur axe de rotation.

A la figure 6 est représentée la plaque 40 obtenue par le procédé décrit ci-avant. Elle définit une pluralité de cartes ou de corps de carte. Cette plaque comprend dans sa zone centrale une couche formée par la résine 22 qui recouvre et entoure latéralement la plaque ajourée 14 et la pluralité d'unités électroniques 2. Les feuilles ou films 18 et 34 peuvent soit définir deux couches des cartes fabriquées, soit former des feuilles de travail qui adhèrent faiblement à la résine et qui sont enlevées par la suite sans détériorer le produit ainsi obtenu. De manière classique, dans la première variante, des impressions peuvent être réalisées sur les couches 18 et 34 et d'autres films, notamment des films transparents, peuvent être apportés de part et d'autre de la plaque 40. Dans la deuxième variante où les feuilles 18 et 34 définissent des feuilles de travail, le produit obtenu après avoir enlever ces feuilles peut former soit des cartes terminées sur lesquelles on peut éventuellement imprimer un motif, soit un produit intermédiaire définissant des corps ou noyaux de cartes. D'autres couches ou films sont ensuite apportés au moins d'un côté de ce produit intermédiaire pour former une pluralité de cartes. Pour obtenir des cartes individuelles, un découpage de chaque carte dans la plaque fabriquée est prévu, notamment selon un contour effectué dans la plaque ajourée 14 qui définit ainsi au moins partiellement les parois latérales des cartes.

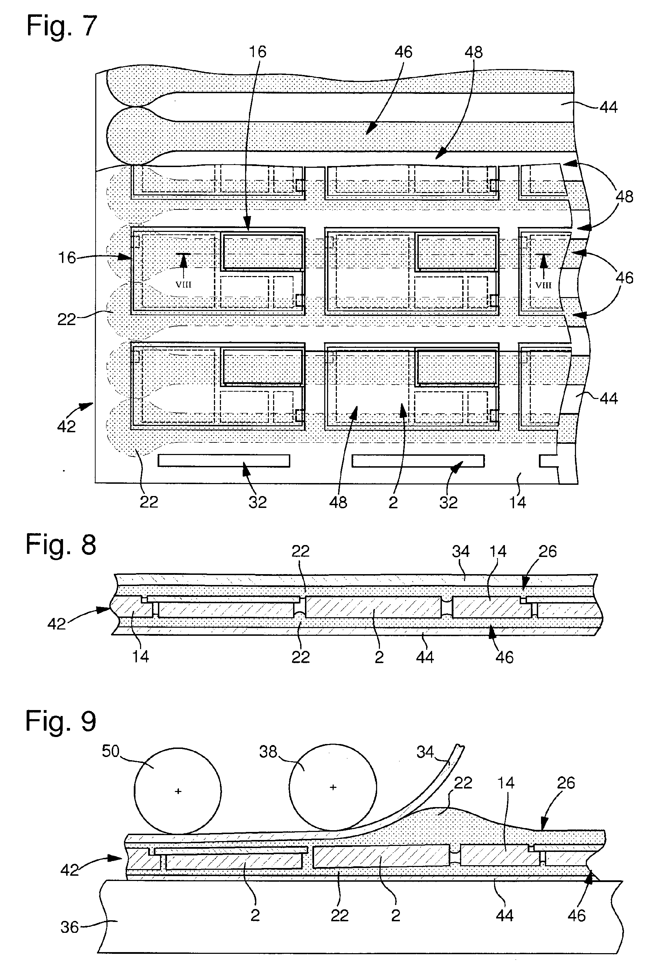

A l'aide des figures 7 à 10, on décrira ci-après un deuxième mode de mise en oeuvre du procédé selon l'invention. Dans ce mode de mise en oeuvre, au moins une partie de la résine 22 est déposée sur une feuille ou une couche 44. Ensuite, la pluralité d'unités électroniques est apportée dessus. Dans la variante représentée, les unités électroniques sont apportées sous forme d'un ensemble 42 formé d'une plaque ajourée 14 et d'une pluralité d'unités électroniques 2 qui sont reliées à la plaque 14 par l'intermédiaire de parties saillantes agencées en périphérie des ouvertures 16 de la plaque 14. Au moins une partie de la résine est apportée sous forme liquide sous la pluralité d'unités électroniques. Selon l'invention, cette première partie de la résine 22 est déposée sous la forme d'une première série de cordons de résine 46 sur la feuille 44. Les cordons de résine 46 définissent entre eux des sillons 48, de manière similaire à ce qui a été décrit précédemment. Ensuite, l'ensemble 42 est déposé sur cette première série de cordons de résine. La plaque 14 présente aussi des réservoirs latéraux 32 destinés à recevoir un surplus de résine et à limiter ou stopper l'écoulement de la résine selon une direction perpendiculaire aux cordons 46. Comme dans le premier mode de mise en oeuvre, la résine est déposée dans une installation comprenant une pluralité de buses servant à former les cordons de résine. A cet effet, l'installation est prévue de manière que la pluralité de buses et la feuille 44 puissent avoir entre elles un mouvement relatif selon la direction X parallèle au plan de cette feuille. Lors du dépôt de la résine sur la feuille 44, la pluralité de buses subit un déplacement selon cette direction X relativement à cette feuille de manière à engendrer les cordons de résine 46 qui présentent initialement entre eux des sillons 48 définissant des canaux d'évacuation de l'air résiduel.

Les figures 8 à 10 représentent une variante préférée du deuxième mode de mise en oeuvre du procédé. Dans cette variante préférée, il est également prévu d'apporter une deuxième partie de la résine sur l'ensemble 42, c'est-à-dire sur les unités électroniques et la plaque ajourée. Ainsi, de manière similaire au premier mode de mise en oeuvre décrit précédemment, une deuxième série de cordons de résine 26 est déposée à l'aide d'une pluralité de buses dans une installation de dépôt de résine. Il est possible d'utiliser la même installation que celle utilisée pour déposer la première série de cordons de résine ou de prévoir une deuxième installation similaire, notamment dans le cas d'une chaine de production où les unités électroniques sont apportées sur la première série de cordons de résine dans une station intermédiaire aux deux installations de dépôt de résine. Finalement, une feuille supérieure 34 est déposée sur la deuxième série de cordons de résine. L'ensemble des éléments représentés à la figure 8 sont apportés dans une installation équipée de moyens d'étalement de la résine 22. Comme cela a déjà été exposé dans le cadre du premier mode de mise en oeuvre, les moyens d'étalement comprennent un dispositif presseur et sont commandés de manière à engendrer un mouvement relatif, sensiblement selon la direction définie par les cordons de résine, entre la pluralité d'unités électroniques 2 et ce dispositif presseur.

Le dispositif de la figure 9 diffère essentiellement de celui de la figure 5 par le fait qu'il est prévu ici au moins deux rouleaux presseurs 38 et 50. Dans la variante représentée, on remarquera aussi que la couche supérieure 34 est déposée progressivement sur les cordons de résine 26 juste avant de passer sous les rouleaux 38 et 50. Le rouleau 38 présente un écartement supérieur, relativement au plan de travail 36, à celui du rouleau presseur 50 agencé à sa suite. Le rouleau presseur 38 sert ainsi à étendre la résine 22 et à remplir les divers espaces restant au niveau de l'ensemble 42. Le rouleau 50 permet de diminuer l'épaisseur de la plaque formée et d'assurer que la résine soit étendue de manière uniforme pour former une plaque sensiblement plane dans la région comprenant la pluralité d'unités électroniques.

D'autres dispositifs presseurs peuvent être utilisés par l'homme du métier. Il est notamment possible d'utiliser des presses à rubans entre lesquels les éléments sont introduits. A titre d'exemple, on peut également prévoir une étape de solidification partielle, notamment par polymérisation, entre les rouleaux presseurs 38 et 50: Finalement; la plaque 52 obtenue à la suite du rouleau 50 peut encore être placée dans une presse à surfaces planes jusqu'à la solidification entière de la résine 22. Cette presse est de préférence prévue sans apport de chaleur.

A l'aide des figures 11 à 13, on décrira ci-après trois variantes pour le dépôt de la résine sous forme de cordons. Ces figures sont schématiques et représentent seulement le dépôt de la résine sur une feuille ou couche inférieure ou sur la pluralité d'unités électroniques. On notera que le procédé selon l'invention peut également s'appliquer pour apporter une couche de résine entre un produit intermédiaire et une feuille de travail ou une couche extérieure apportée sur ou sous le produit intermédiaire.

On remarquera ici que les variantes proposées aux figures 11 à 13 ont pour objectif commun de minimiser les pertes de résine en optimisant l'étalement de celle-ci dans l'installation d'application d'une pression sur les cordons de résine. En effet, dans le cadre de la présente invention, il a été observé que la résine, dans la phase finale d'application de la pression, ne définit pas une vague avec un front rectiligne, mais généralement avec un front bombé, c'est-à-dire avec plus de résine dans la région centrale que dans les deux bords latéraux de la plaque fabriquée. Il en résulte donc une perte de résine étant donné qu'il est nécessaire d'assurer que la résine s'étale uniformément au dessus de toutes les unités électroniques de manière à remplir entièrement les ouvertures de la plaque ajourée dans laquelle elles sont agencées. On cherche donc à limiter les pertes de résine sur les deux côtés latéraux de la plaque fabriquée et à obtenir un front de résine le plus rectiligne possible en fin de parcours des rouleaux presseurs, de manière à obtenir une dernière rangée de cartes (aux figures sur la droite de la plaque fabriquée) sensiblement sans air résiduel et présentant une même épaisseur que les autres cartes des rangées précédentes.

Dans la variante de la figure 11, les cordons de résine 26, respectivement 46 présentent un écartement E variable, c'est-à-dire que cet écartement n'est pas le même entre au moins deux paires de cordons de résine adjacents. A l'extrémité gauche correspondant à l'extrémité depuis laquelle le rouleau presseur étale la résine, il est prévu une zone continue de résine 30. Pour obtenir un écartement variable entre les cordons, c'est-à-dire des sillons de largeurs variables, la pluralité de buses est agencée de manière correspondante avec des écartements entre deux buses adjacentes qui sont également variables. Dans la variante de la figure 12, l'écartement entre les cordons de résine 26, respectivement 46 est sensiblement constant, par contre les largeurs respectives de ces cordons sont variables. Pour obtenir des cordons avec des largeurs variables, il suffit de prévoir des buses présentant des ouvertures de largeurs variables ou/et des débits variables parmi la pluralité de buses. La distribution des largeurs de cordon est donnée ici à titre d'exemple nullement limitatif. Les cordons extérieurs présentent une moindre largeur et les autres cordons présentent ensuite une largeur plus importante qui diminue ensuite en direction des cordons situés dans la région centrale de la série de cordons.

Finalement à la figure 13, les cordons de résine 26, respectivement 46 présentent entre eux des écartements sensiblement constants et ont des largeurs sensiblement identiques, mais ces cordons de résine présentent des longueurs variables, c'est-à-dire que chaque cordon est déposé sur une certaine longueur qui dépend de la position du cordon considéré dans la série de cordons déposés. Ainsi, au moins deux cordons de résine présentent dans cette variante des longueurs différentes. Pour ce faire, il est possible de commander l'apport de résine à chacune des buses de manière indépendante ou par groupe de buses servant à former des cordons de mêmes longueurs. On peut également prévoir des buses susceptibles d'avoir des mouvements relatifs entre elles. Ainsi, par exemple, les buses sont alignées selon une droite au commencement du dépôt (à l'extrémité gauche sur la figure 13), et ensuite au moins certaines buses sont déplacées selon l'axe X de manière à définir ensemble une courbe correspondant à la courbe terminale définie par les extrémités 56 des cordons déposés. On peut encore imaginer une matrice de buses avec certaines lignes ayant moins de buses que d'autres ou une matrice de buses alimentées par groupe sur des périodes différentes. L'homme du métier a plusieurs possibilités techniques pour réaliser une installation de dépôt de résine pour la mise en oeuvre du procédé de fabrication de cartes selon l'invention.

## Revendications

1. Procédé de fabrication de cartes dans lequel il est prévu de réaliser une pluralité de cartes ou de corps de carte sous forme d'une plaque ou bande (40; 52) comprenant une pluralité d'unités électroniques (2) et une résine (22) enrobant au moins partiellement ces unités électroniques, chaque carte ou corps de carte étant finalement découpé dans cette plaque ou bande, ce procédé ayant une étape d'apport d'au moins une partie de ladite résine sous forme liquide sur ladite pluralité d'unités électroniques et étant **caractérisé en ce que**:
- ladite au moins une partie de ladite résine est déposée sur ladite pluralité d'unités électroniques au moyen d'une pluralité de buses dans une installation d'apport de cette résine, cette installation étant agencée de manière que la pluralité de buses et la pluralité d'unités électroniques apportées dans cette installation puissent avoir entre elles un mouvement relatif selon une direction (X) ayant au moins une composante horizontale;
- ladite pluralité de buses subit, lors dudit dépôt de ladite au moins une partie de ladite résine, un déplacement relativement à ladite pluralité d'unités électroniques selon ladite direction de manière à engendrer sur ladite pluralité d'unités électroniques des cordons de résine (26) orientés selon cette direction et présentant initialement entre eux des sillons (28); et
- ladite résine déposée est étendue progressivement selon ladite direction (X) par des moyens (34, 38) d'étalement de cette résine, ladite pluralité d'unités électroniques et ces moyens d'étalement ayant entre eux un mouvement relatif selon ladite direction.

2. Procédé de fabrication de cartes dans lequel il est prévu de réaliser une pluralité de cartes ou de corps de carte sous forme d'une plaque ou bande (52) comprenant une pluralité d'unités électroniques (2) et une résine (22) enrobant au moins partiellement ces unités électroniques, chaque carte ou corps de carte étant finalement découpé dans cette plaque ou bande, ce procédé ayant une étape d'apport d'au moins une première partie de ladite résine sous forme liquide sous ladite pluralité d'unités électroniques et étant **caractérisé en ce que**:
- ladite au moins une première partie de ladite résine est déposée sur une feuille ou couche (18), au-dessus de laquelle il est prévu ensuite d'agencer ladite pluralité d'unités électroniques, au moyen d'une pluralité de buses dans une installation d'apport de cette résine, cette installation étant agencée de manière que la pluralité de buses et la feuille ou couche apportée dans cette installation puissent avoir entre elles un mouvement relatif selon une première direction sensiblement parallèle à cette feuille ou couche dans la zone de dépôt de la résine;
- ladite pluralité de buses subit, lors dudit dépôt de ladite au moins une première partie de ladite résine sur ladite feuille ou couche, un déplacement relativement à cette feuille ou couche selon ladite première direction de manière à engendrer une première série de cordons de résine (46) orientés selon cette première direction et présentant initialement entre eux des sillons (48); et
- ladite pluralité d'unités électroniques est apportée sur ladite première série de cordons de résine.

3. Procédé selon la revendication 2 dans lequel il est également prévu d'apporter une deuxième partie de ladite résine sous forme liquide sur ladite pluralité d'unités électroniques, ce procédé étant **caractérisé en ce que**:
- ladite deuxième partie de ladite résine est déposée sur ladite pluralité d'unités électroniques (2) au moyen d'une pluralité de buses dans une installation d'apport de cette résine, cette installation étant agencée de manière que la pluralité de buses et la pluralité d'unités électroniques apportées dans cette installation puissent avoir entre elles un mouvement relatif selon une deuxième direction sensiblement parallèle à ladite feuille ou couche dans la zone de dépôt de cette deuxième partie de la résine;
- ladite pluralité de buses subit, lors dudit dépôt de ladite deuxième partie de ladite résine sur ladite pluralité d'unités électroniques, un déplacement relativement à cette pluralité d'unités électroniques selon ladite deuxième direction de manière à engendrer sur cette pluralité d'unités électroniques une deuxième série de cordons de résine (26) orientés selon cette deuxième direction et présentant initialement entre eux des sillons (28); et
- ladite deuxième partie de la résine déposée sur la pluralité d'unités électroniques est ensuite étendue progressivement selon ladite deuxième direction (X) par des moyens (34, 38) d'étalement de cette deuxième partie de la résine, ladite pluralité d'unités électroniques et ces moyens d'étalement ayant entre eux un mouvement relatif selon ladite deuxième direction.

4. Procédé selon la revendication 3, **caractérisé en ce que** ladite deuxième direction est parallèle à ladite première direction.

5. Procédé selon la revendication 4, **caractérisé en ce que** la viscosité de la première partie de résine apportée initialement sur ladite feuille ou couche et l'apport de la pluralité d'unités électroniques sont prévus pour que lesdits moyens d'étalement de la deuxième partie de la résine servent également à étaler, au moins dans une phase terminale de l'étalement de la première partie de la résine, cette première partie de résine.

6. Procédé selon l'une des revendications précédentes, **caractérisé en ce que** des cordons de résine déposés présentent entre eux des espacements variables.

7. Procédé selon l'une des revendications précédentes, **caractérisé en ce que** des cordons de résine déposés présentent des largeurs variables.

8. Procédé selon l'une des revendications précédentes, **caractérisé en ce que** des cordons de résine sont déposés chacun sur une certaine longueur, au moins deux cordons de résine ayant des longueurs différentes.

9. Procédé selon l'une des revendications précédentes, **caractérisé en ce qu'**une structure (14) présentant une pluralité d'ouvertures est également apportée, ladite pluralité d'unités électroniques étant agencée dans cette pluralité d'ouvertures de la structure.

## Claims

1. Card manufacturing method wherein a plurality of cards or card bodies are made in the form of a plate or strip (40; 52) that includes a plurality of electronic units (2) and a resin (22) that at least partially coats said electronic units, wherein each card or card body is eventually cut out of said plate or strip, and wherein the method includes a step of providing at least one part of said resin in liquid form over said plurality of electronic units and is **characterized in that**:
- said at least one part of said resin is deposited over said plurality of electronic units by means of a plurality of nozzles in a resin feed installation, said installation being arranged such that there can be a relative movement between the plurality of nozzles and the plurality of electronic units brought into said installation along a direction (X) that has at least one horizontal component;
- during said deposition of said at least one part of said resin, said plurality of nozzles undergoes a movement relative to said plurality of electronic units along said direction so as to generate strings of resin (26) on said plurality of electronic units, said strings being oriented along said direction and initially having grooves (28) between them; and
- said deposited resin is gradually spread out along said direction (X) by means (34, 38) for spreading said resin, and there is a relative movement between said plurality of electronic units and said spreading means along said direction.

2. Card manufacturing method wherein a plurality of cards or card bodies are made in the form of a plate or strip (52) including a plurality of electronic units (2) and a resin (22) that at least partially coats said electronic units, wherein each card or card body is eventually cut out of said plate or strip, and wherein the method has a step of providing at least a first part of said resin in liquid form underneath said plurality of electronic units and is **characterized in that**:
- said at least first part of said resin is deposited on a sheet or layer (18), above which said plurality of electronic units is then arranged, by means of a plurality of nozzles in a resin feed installation, said installation being arranged such that there is a relative movement between the plurality of nozzles and the sheet or layer brought into said installation along a first direction that is approximately parallel to said sheet or layer in the resin deposition area;
- during said deposition of said at least first part of said resin on said sheet or layer, said plurality of nozzles undergoes a movement relative to said sheet or layer along said first direction so as to generate a first series of strings of resin (46), which are oriented along said first direction and initially have grooves (48) between them; and
- said plurality of electronic units is placed on said first series of strings of resin.

3. Method according to claim 2, wherein a second part of said resin is also provided in liquid form on said plurality of electronic units, said method being **characterized in that**:
- said second part of said resin is deposited on said plurality of electronic units (2) by means of a plurality of nozzles in a resin feed installation, said installation being arranged such that there is a relative movement between the plurality of nozzles and the plurality of electronic units brought into said installation along a second direction approximately parallel to said sheet or layer in the deposition area of said second part of the resin;
- during said deposition of said second part of said resin on said plurality of electronic units, said plurality of nozzles undergoes a movement relative to the plurality of electronic units along said second direction so as to generate, on said plurality of electronic units, a second series of resin strings (26), which are oriented along said second direction and initially have grooves (28) between them; and
- said second part of the resin deposited on the plurality of electronic units is then gradually spread out along said second direction (X) by means (34, 38) for spreading said second part of the resin, and there is a relative movement between said plurality of electronic units and said spreading means along said second direction.

4. Method according to claim 3, **characterized in that** said second direction is parallel to said first direction.

5. Method according to claim 4, **characterized in that** the viscosity of the first part of the resin initially provided on said sheet or layer and the providing of the plurality of electronic units are such that said means for spreading the second part of the resin are also used for spreading said first resin part, at least in an end phase of spreading the first resin part.

6. Method according to any of the preceding claims, **characterized in that** the spacing between the deposited resin strings is variable.

7. Method according to any of the preceding claim, **characterized in that** the widths of the deposited resin strings are variable.

8. Method according to any of the preceding claims, **characterized in that** resin strings are each deposited over a certain length, with at least two resin strings having different lengths.

9. Method according to any of the preceding claims, **characterized in that** a structure (14) that has a plurality of apertures is also provided, and **in that** said plurality of electronic units is arranged in said plurality of apertures of the structure.

## Patentansprüche

1. Verfahren zum Herstellen von Karten, bei dem vorgesehen ist, mehrere Karten oder Kartenkörper in Form einer Platte oder eines Bandes (40; 52), die bzw. das mehrere elektronische Einheiten (2) und ein diese elektronischen Einheiten wenigstens teilweise umgebendes Harz (22) enthält, zu verwirklichen, wobei jede Karte oder jeder Kartenkörper schließlich aus dieser Platte oder aus diesem Band ausgeschnitten wird, wobei dieses Verfahren einen Schritt des Vorsehens wenigstens eines Teils des Harzes in flüssiger Form auf den mehreren elektronischen Einheiten umfasst und **dadurch gekennzeichnet ist, dass**:
- der wenigstens eine Teil des Harzes auf die mehreren elektronischen Karten mittels mehrerer Düsen in einer Anlage zum Einbringen dieses Harzes aufgebracht wird, wobei diese Anlage so ausgelegt ist, dass die mehreren Düsen und die mehreren elektronischen Einheiten, die in dieser Anlage vorgesehen werden, zwischen sich eine Relativbewegung in einer Richtung (X), die wenigstens eine horizontale Komponente besitzt, aufweisen können;
- die mehreren Düsen dann, wenn wenigstens der eine Teil des Harzes aufgebracht wird, einer Verlagerung relativ zu den mehreren elektronischen Einheiten in dieser Richtung unterworfen werden, derart, dass auf den mehreren elektronischen Einheiten Harzstreifen (26) erzeugt werden, die in dieser Richtung orientiert sind und zunächst zwischen sich Furchen (28) aufweisen; und
- das aufgebrachte Harz allmählich in der Richtung (X) durch Mittel (34, 38) zum Verteilen dieses Harzes ausgebreitet wird, wobei die mehreren elektronischen Einheiten und diese Verteilungsmittel zwischen sich eine Relativbewegung in dieser Richtung aufweisen.

2. Verfahren zum Herstellen von Karten, bei dem vorgesehen ist, mehrere Karten oder Kartenkörper in Form einer Platte oder eines Bandes (52), die bzw. das mehrere elektronische Einheiten (2) und ein diese elektronischen Einheiten wenigstens teilweise umgebendes Harz (22) enthält, zu verwirklichen, wobei jede Karte oder jeder Kartenkörper schließlich aus dieser Platte oder aus diesem Band ausgeschnitten wird, wobei dieses Verfahren einen Schritt des Vorsehens wenigstens eines Teil des Harzes in flüssiger Form unter den mehreren elektronischen Einheiten umfasst und **dadurch gekennzeichnet ist, dass**:
- wenigstens der erste Teil des Harzes auf eine Lage oder Schicht (18), auf der später die mehreren elektronischen Einheiten angeordnet werden sollen, mittels mehrerer Düsen in einer Anlage zum Einbringen dieses Harzes aufgebracht wird, wobei diese Anlage so ausgelegt ist, dass die mehreren Düsen und die Lage oder Schicht, die in dieser Anlage vorgesehen wird, zwischen sich eine Relativbewegung in einer ersten Richtung, die zu dieser Lage oder Schicht in der Zone des Aufbringens des Harzes im Wesentlichen parallel ist, aufweisen können;
- die mehreren Düsen bei der Aufbringung wenigstens des ersten Teils des Harzes auf die Lage oder Schicht einer Verlagerung relativ zu dieser Lage oder Schicht in dieser ersten Richtung unterworfen werden, derart, dass eine erste Reihe von Harzstreifen (46), die in dieser ersten Richtung orientiert sind und zunächst zwischen sich Furchen (48) aufweisen, erzeugt wird; und
- die mehreren elektronischen Einheiten auf die erste Reihe von Harzstreifen aufgebracht werden.

3. Verfahren nach Anspruch 2, wobei außerdem vorgesehen ist, einen zweiten Teil des Harzes in flüssiger Form auf den mehreren elektronischen Einheiten vorzusehen, wobei dieses Verfahren **dadurch gekennzeichnet ist, dass**:
- der zweite Teil des Harzes auf die mehreren elektronischen Einheiten (2) mittels mehrerer Düsen in einer Anlage zum Einbringen dieses Harzes aufgebracht wird, wobei diese Anlage so ausgelegt ist, dass die mehreren Düsen und die mehreren elektronischen Einheiten, die in dieser Anlage vorgesehen werden, zwischen sich eine Relativbewegung in einer zweiten Richtung, die zu der Lage oder Schicht in der Zone der Aufbringung dieses zweiten Teils dieses Harzes im Wesentlichen parallel ist, haben können;
- die mehreren Düsen bei der Aufbringung des zweiten Teils des Harzes auf die mehreren elektronischen Einheiten einer Verlagerung relativ zu diesen mehreren elektronischen Einheiten in der zweiten Richtung unterworfen werden, derart, dass auf diesen mehreren elektronischen Einheiten eine zweite Reihe von Harzstreifen (26), die in dieser zweiten Richtung orientiert sind und zunächst zwischen sich Furchen (28) aufweisen, erzeugt wird; und
- der zweite Teil des Harzes, der auf die mehreren elektronischen Einheiten aufgebracht wird, anschließend allmählich in dieser zweiten Richtung (X) durch Mittel (34, 38) zum Verteilen dieses zweiten Teils des Harzes ausgebreitet wird, wobei die mehreren elektronischen Einheiten und diese Verteilungsmittel zwischen sich eine Relativbewegung in dieser zweiten Richtung aufweisen.

4. Verfahren nach Anspruch 3, **dadurch gekennzeichnet, dass** die zweite Richtung zu der ersten Richtung parallel ist.

5. Verfahren nach Anspruch 4, **dadurch gekennzeichnet, dass** die Viskosität des ersten Teils des Harzes, der zunächst auf der Lage oder Schicht vorgesehen wird, und das Vorsehen der mehreren elektronischen Einheiten dazu vorgesehen sind, dass die Mittel zum Verteilen des zweiten Teils des Harzes außerdem dazu dienen, wenigstens in einer Endphase des Verteilens des ersten Teils des Harzes auch diesen zweiten Teil des Harzes zu verteilen.

6. Verfahren nach einem der vorhergehenden Ansprüche, **dadurch gekennzeichnet, dass** die aufgebrachten Harzstreifen zwischen sich veränderliche Zwischenräume aufweisen.

7. Verfahren nach einem der vorhergehenden Ansprüche, **dadurch gekennzeichnet, dass** die aufgebrachten Harzstreifen veränderliche Breiten aufweisen.

8. Verfahren nach einem der vorhergehenden Ansprüche, **dadurch gekennzeichnet, dass** die Harzstreifen jeweils auf einer bestimmten Länge aufgebracht werden, wobei wenigstens zwei Harzstreifen unterschiedliche Längen haben.

9. Verfahren nach einem der vorhergehenden Ansprüche, **dadurch gekennzeichnet, dass** außerdem eine Struktur (14), die mehrere Öffnungen aufweist, vorgesehen wird, wobei die mehreren elektronischen Einheiten in diesen mehreren Öffnungen der Struktur angeordnet werden.
